# EUROPEAN PATENT APPLICATION

(11) **EP 4 235 763 A1**
(43) Date of publication of application: **30.08.2023**
(21) Application number: 22190017.8
(22) Date of filing: 11.08.2022
(51) Int. Cl.: H01L 21/8234, H01L 27/088

(54) **SEMICONDUCTOR DEVICE AND METHOD FOR FABRICATING THE SAME**

(30) Priority: 24.02.2022 CN 202210171997
(71) Applicant: United Microelectronics Corp., Hsin-Chu City 300 (TW)
(72) Inventor: HSU, Chia-Jung, 744 Tainan City (TW); FU, Ssu-I, 825 Kaohsiung City (TW); HSU, Chih-Kai, 710 Tainan City (TW); CHIU, Chun-Ya, 741 Tainan City (TW); CHEN, Chin-Hung, 710 Tainan City (TW); LIN, Yu-Hsiang, 235 New Taipei City (TW); LIN, Chien-Ting, 741 Tainan City (TW)
(74) Representative: Isarpatent

(57) **Abstract**

A method for fabricating a semiconductor device includes the steps of providing a substrate having a high voltage (HV) region and a low voltage (LV) region, forming first fin-shaped structures (20) on the HV region, and then performing an oxidation process to form a gate oxide layer (46) on and directly connecting the first fin-shaped structures. Preferably, a bottom surface of the gate oxide layer includes first bumps (48) on the first fin-shaped structures while a top surface of the gate oxide layer includes second bumps (50).

## Description

### Background of the Invention

The invention relates to a method of fabricating semiconductor device, and more particularly to a method of integrating high voltage (HV) device and low voltage (LV) device.

In current semiconductor processing, controllers, memories, circuits of low-voltage operation and power devices of high-voltage operation are largely integrated into a single chip to achieve a single-chip system. The power device or high voltage (HV) device, such as vertical double-diffusion metal-oxide-semiconductor (VDMOS), insulated gate bipolar transistor (IGBT) and lateral diffusion MOS (LDMOS), is employed to increase power switching efficiency and decrease the loss of energy resources. It is often required that the switching transistors withstand high breakdown voltages and operate at a low on-resistance.

Moreover with the trend in the industry being towards scaling down the size of the metal oxide semiconductor transistors (MOS), three-dimensional or non-planar transistor technology, such as fin field effect transistor technology (FinFET) has been developed to replace planar MOS transistors. Since the three-dimensional structure of a FinFET increases the overlapping area between the gate and the fin-shaped structure of the silicon substrate, the channel region can therefore be more effectively controlled. This way, the drain-induced barrier lowering (DIBL) effect and the short channel effect are reduced. The channel region is also longer for an equivalent gate length, thus the current between the source and the drain is increased. In addition, the threshold voltage of the fin FET can be controlled by adjusting the work function of the gate.

However as the scale of current devices continue to decrease the integration of high-voltage devices and FinFET devices start to face numerous challenges such as current leakage and control of breakdown voltage. Hence, how to improve the current fabrication for improving performance of the device has become an important task in this field.

### Summary of the Invention

According to an embodiment of the present invention, a method for fabricating a semiconductor device includes the steps of providing a substrate having a high voltage (HV) region and a low voltage (LV) region, forming first fin-shaped structures on the HV region, and then performing an oxidation process to form a gate oxide layer on and directly connecting the first fin-shaped structures. Preferably, a bottom surface of the gate oxide layer includes first bumps on the first fin-shaped structures while a top surface of the gate oxide layer includes second bumps.

According to another aspect of the present invention, a semiconductor device includes a substrate having a high voltage (HV) region and a low-'voltage (LV) region, first fin-shaped structures on the HV region, a gate oxide layer on and connecting the first fin-shaped structures, second fin-shaped structures adjacent to two sides of the first fin-shaped structures on the HV region, third fin-shaped structures on the LV region, a first shallow trench isolation (STI) around the first fin-shaped structures, the second fin-shaped structures, and the third fin-shaped structures, a second STI between the first fin-shaped structures and the second fin-shaped structures, and epitaxial layers on the second fin-shaped structures.

These and other objectives of the present invention will no doubt become obvious to those of ordinary skill in the art after reading the following detailed description of the preferred embodiment that is illustrated in the various figures and drawings.

### Brief Description of the Drawings

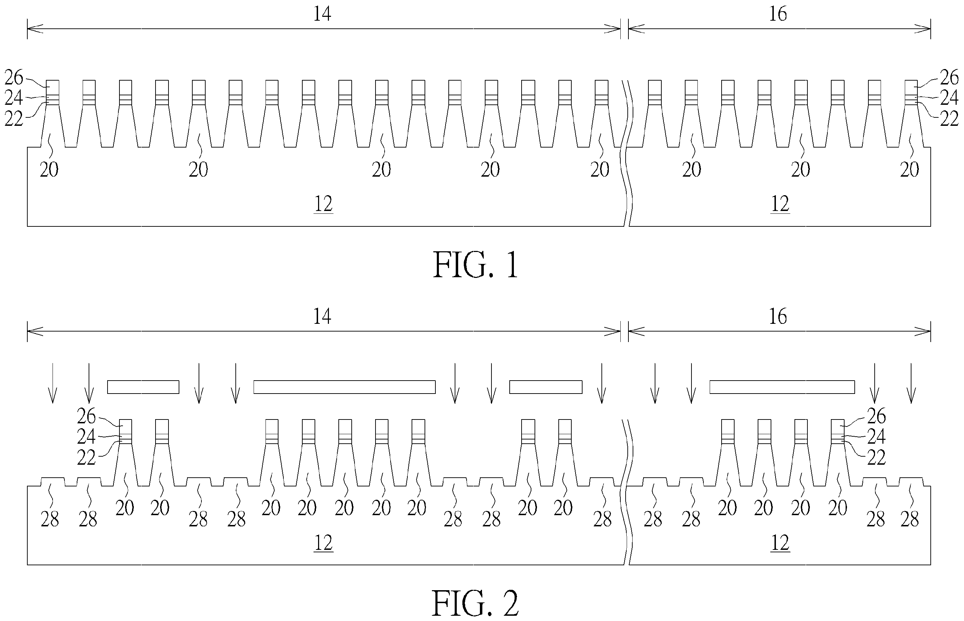

Figs. 1-11 illustrate a method for fabricating a semiconductor device according to an embodiment of the present invention.

### Detailed Description

Referring to Figs. 1-11, Figs. 1-11 illustrate a method for fabricating a semiconductor device according to an embodiment of the present invention. As shown in Fig. 1, a substrate 12, such as a silicon substrate or silicon-on-insulator (SOI) substrate is provided and two or more transistor regions, such as a high voltage (HV) region 14 and a low voltage (LV) region 16 are defined on the substrate 12, in which at least a HV device will be formed on the HV region 14 while at least a LV device will be formed on the LV region 16 in the later process. In this embodiment, the HV region 14 and the LV region 16 could be transistor regions having same conductive type or different conductive types. For instance, each of the two regions 14, 16 could be a PMOS region or a NMOS region and the two regions 14 and 16 are defined to fabricate gate structures having different threshold voltages in the later process. Preferably, it would be desirable to first conduct an implantation process to form p-type deep wells on the HV region 14 and n-type deep wells on the LV region 16, but not limited thereto.

Next, a plurality of fin-shaped structures 20 are formed on the substrate 12 of the HV region 14 and the LV region 16. Preferably, the fin-shaped structures 20 could be obtained by a sidewall image transfer (SIT) process. For instance, a layout pattern is first input into a computer system and is modified through suitable calculation. The modified layout is then defined in a mask and further transferred to a layer of sacrificial layer on a substrate through a photolithographic and an etching process. In this way, several sacrificial layers distributed with a same spacing and of a same width are formed on a substrate. Each of the sacrificial layers may be stripe-shaped. Subsequently, a deposition process and an etching process are carried out such that spacers are formed on the sidewalls of the patterned sacrificial layers. In a next step, sacrificial layers can be removed completely by performing an etching process. Through the etching process, the pattern defined by the spacers can be transferred into the substrate underneath, and through additional fin cut processes, desirable pattern structures, such as stripe patterned fin-shaped structures could be obtained.

Alternatively, the fin-shaped structures 20 could also be obtained by first forming a patterned mask (not shown) on the substrate, 12, and through an etching process, the pattern of the patterned mask is transferred to the substrate 12 to form the fin-shaped structures 20. Moreover, the formation of the fin-shaped structures 20 could also be accomplished by first forming a patterned hard mask (not shown) on the substrate 12, and a semiconductor layer composed of silicon germanium is grown from the substrate 12 through exposed patterned hard mask via selective epitaxial growth process to form the corresponding fin-shaped structures 20. These approaches for forming the fin-shaped structures 20 are all within the scope of the present invention.

In this embodiment, a liner 22, a liner 24, and a hard mask 26 could be formed on each of the fin-shaped structures 20 during the aforementioned patterning process, in which the liner 22 preferably includes silicon oxide (SiO₂), the liner 24 includes silicon nitride (SiN), and the hard mask 26 includes silicon oxide (SiO₂), but not limited thereto.

Next, as shown in Fig. 2, a fin removal and/or a fin cut process is conducted to remove part of the fin-shaped structures 20 on the HV region 14 and LV region 16 for forming bumps 28 adjacent to the fin-shaped structures 20. In this embodiment, the fin removal process is employed to remove part of the fin-shaped structures extending along the same direction while the fin cut process is conducted to divide the round shape fin-shaped structures in a top view perspective into a plurality of separate and independent fin-shaped structures all extending along the same direction.

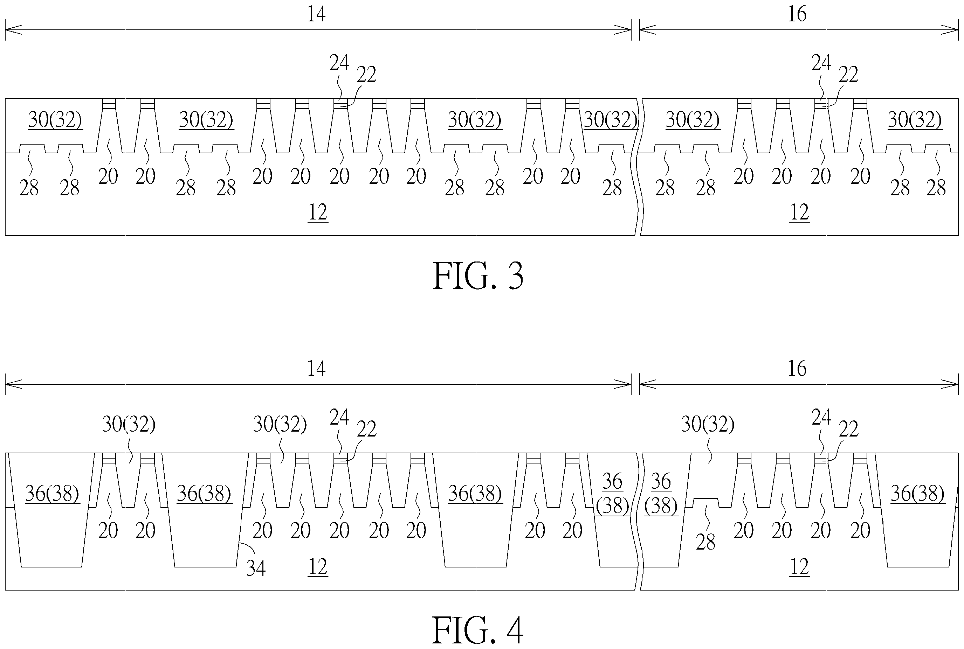

Next, as shown in Fig. 3, a flowable chemical vapor deposition (FCVD) process is conducted to form an insulating layer 30 made of SiONH on the bumps 28 and the fin-shaped structures 20 and filling the trenches between the fin-shaped structures 20, and a planarizing process such as chemical mechanical polishing (CMP) process is conducted to remove part of the insulating layer 30 and the hard mask 26 so that the top surfaces of the liner 24 and the insulating layer 30 are coplanar. Preferably, the remaining insulating layer 30 around the fin-shaped structures 20 on the LV region 16 at this stage now becomes a shallow trench isolation (STI) 32.

Next, as shown in Fig. 4, a photo-etching process is conducted by first forming a patterned mask (not shown) such as patterned resist on the HV region 14 and LV region 16 and exposing part of the STI 30 surface, and then conducting an etching process by using the patterned mask as mask to remove part of the STI 32, part of the bumps 28, and part of the substrate 12 on the HV region 14 and LV region 16 to form a plurality of trenches 34 as the depth of the trenches 34 is substantially greater than the depth of the trenches between the fin-shaped structures 20.

Next, a sub-atmospheric chemical vapor deposition (SACVD) process is conducted to form another insulating layer 36 on the HV region 14 and LV region 16 and filling the trenches 34 completely, and then a planarizing process such as a CMP process is conducted to remove part of the insulating layer 36. At this stage, the remaining insulating layer 36 on the HV region 14 and LV region 16 preferably becomes a STI 38 while the top surfaces of the STI 38 and the STI 32 are coplanar. It should be noted that the insulating layer 36 formed at this stage and the insulating layer 30 formed in Fig. 3 are preferably made of different materials. For instance, the insulating layer 30 or the STI 32 formed in Fig. 3 is made of SiONH while the insulating layer 36 or STI 38 formed at this stage is made of SiO₂.

It should further be noted that the SACVD process conducted at this stage preferably uses tetraethyl orthosilicate (TEOS) and ozone (O₃) as precursor and silicon dioxide as sedimentary deposit in the later stage. The FCVD process conducted in Fig. 3 on the other hand uses trisilyamine, ammonia gas (NH₃), and oxygen gas (O₂) as precursor and SiONH as sedimentary deposit in the later stage.

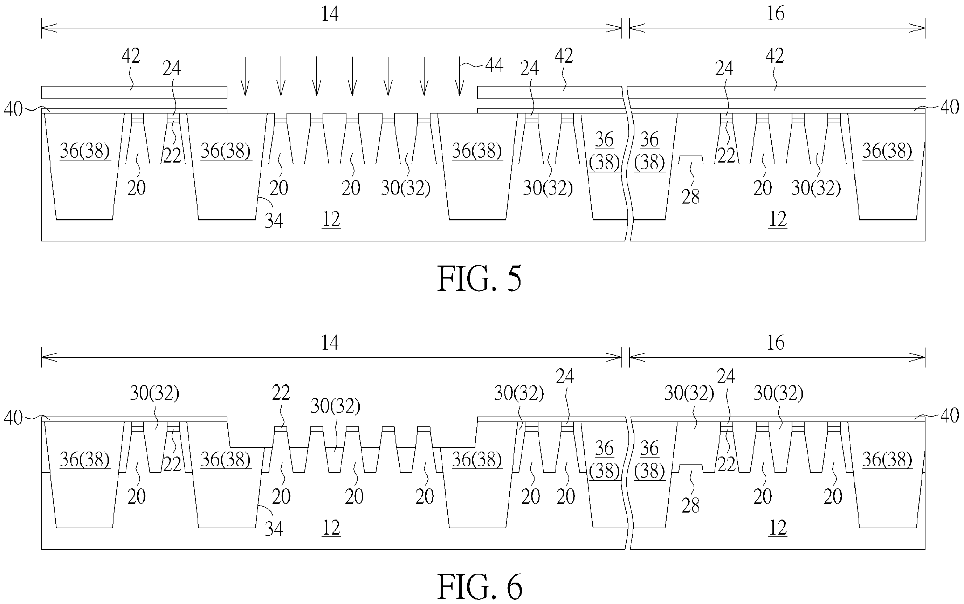

Next, as shown in Fig. 5, a hard mask 40 made of silicon nitride is formed to cover the surface of the STIs 32, 38 on the HV region 14 and LV region 16, a patterned mask 42 such as a patterned resist is formed on the hard mask 40, and then an etching process 44 is conducted by using the patterned mask 42 as mask to remove part of the hard mask 40 and part of the liner 24 also made of silicon nitride on the HV region 14 as none of the STIs 32, 38 and fin-shaped structures 20 is removed.

Next, as shown in Fig. 6, another etching process is conducted by using the patterned mask 42 as mask to remove part of the STI 32 and part of the STI 38 on the HV region 14 so that the top surface of the remaining STIs 32, 38 is slightly lower than the top surface of the fin-shaped structures 20. It should be noted that when part of the STIs 32, 38 are removed by the etching process, the liner 22 made of silicon oxide is still remained on the top surface of the fin-shaped structures 20. Nevertheless, according to other embodiment of the present invention the liner 22 could also be removed when part of the STIs 32, 38 are removed to expose the top surface of the fin-shaped structures, which is also within the scope of the present invention.

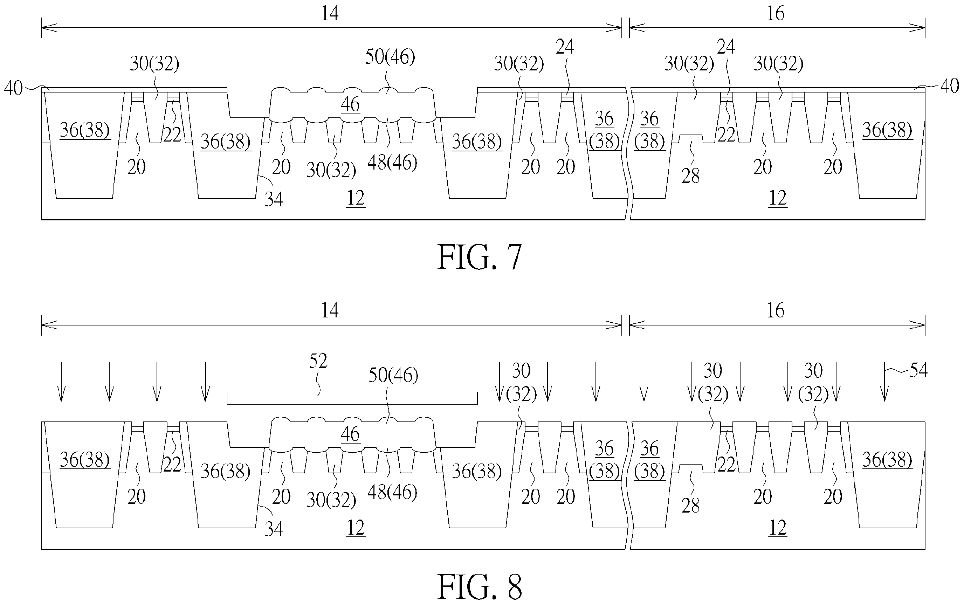

Next, as shown in Fig. 7, an oxidation process is conducted to form a gate oxide layer 46 on the fin-shaped structures 20 on the HV region 14. Specifically, the oxidation process is accomplished by using furnace to react the remaining liners 22 made of silicon oxide for forming a gate oxide layer 46 standing across on multiple fin-shaped structures 20 at the same, in which the gate oxide layer 46 contacts the plurality of fin-shaped structures 20 directly. Structurally, the bottom surface of the gate oxide layer 46 includes a plurality of bumps 48 directly contacting the plurality of fin-shaped structures 20 and the top surface of the gate oxide layer 46 also includes a plurality of bumps 50, in which the bumps 50 on the top surface correspond to the bumps 48 on the bottom surface, the width of each bump 50 on the top is slightly less than the width of each bump 48 on the bottom, and the overall size or volume of each bump 50 on the top is slightly less than the overall size or volume of each bump 48 on the bottom, but not limited thereto.

Next, as shown in Fig. 8, a patterned mask 52 such as patterned resist is formed on the gate oxide layer 46 and part of the STI 38 on HV region 14, and an etching process 54 is conducted by using the patterned mask 52 as mask to remove all of the hard mask 40 and liner 24 on the HV region 14 and LV region 16 for exposing the liner 22 underneath.

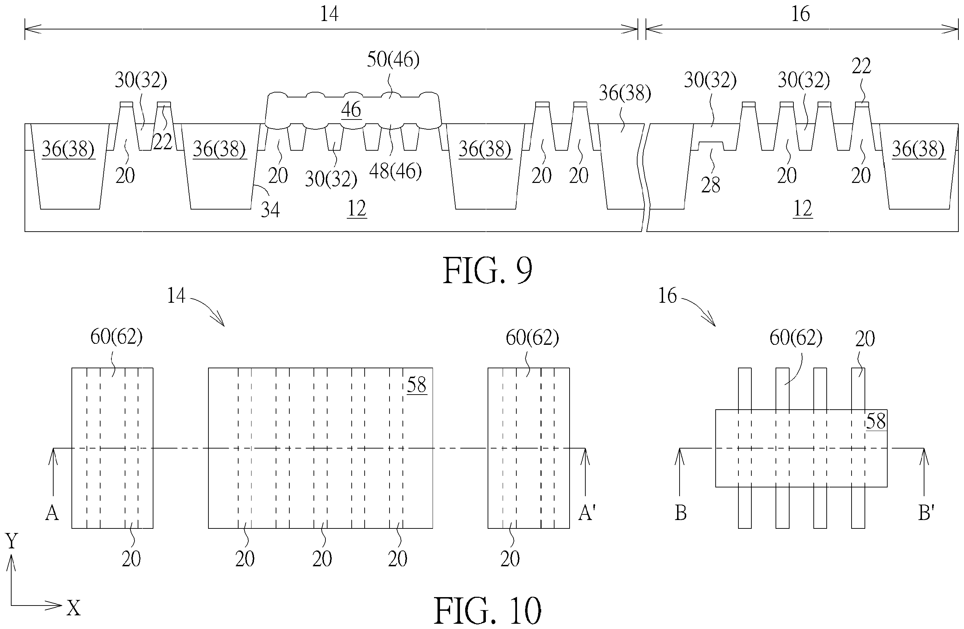

Next, as shown in Fig. 9, another etching process is conducted with or without using the patterned mask 52 to remove part of the STIs 32, 38 on the HV region 14 and LV region 16 so that the top surface of the STIs 32, 38 is slightly lower than the top surface of the fin-shaped structures 20. In this embodiment, the top surface of the remaining STIs 32, 38 could be higher than, even with, or lower than the bottom surface of the gate oxide layer 46 or more specifically the interface between the gate oxide layer 46 and the lower bumps 48 or the bottom surface of the bumps 48, which are all within the scope of the present invention.

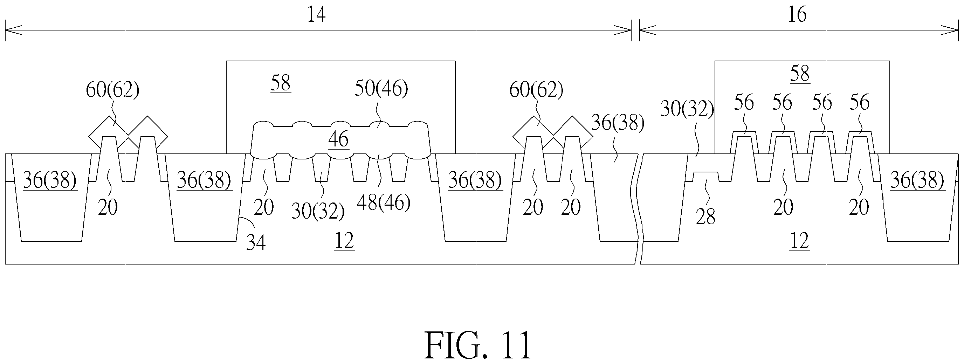

Referring to Figs. 10-11, Figs. 10-11 illustrate a method for fabricating a semiconductor device following Fig. 9, in which Fig. 10 illustrates a top view for fabricating the semiconductor device and Fig. 11 illustrates a cross-section view for fabricating the semiconductor device taken along the sectional line AA' and BB' of Fig. 10. As shown in Figs. 10-11, it would be desirable to remove the liner 22 on the HV region 14 and LV region 16, conduct one or more oxidation process such as in-situ steam generation (ISSG) process to form a gate oxide layer 56 made of silicon oxide on the fin-shaped structures 20 on the LV region 16.

Next, gate structures 58 or dummy gates could be formed on the fin-shaped structures 20 on the HV region 14 and LV region 16. In this embodiment, the formation of the gate structures 58 could be accomplished by a gate first process, a high-k first approach from gate last process, or a high-k last approach from gate last process. For example, it would be desirable to form a spacer adjacent to each of the gate structures 58, form a source/drain region 60 and/or epitaxial layers 62 in the substrate 12 adjacent to the spacer, form an interlayer dielectric (ILD) layer (not shown) around the gate structures 58, and then selectively conduct a replacement metal gate (RMG) process to transform the gate structures 58 into metal gates. Since the transformation of dummy gate structures into metal gates through RMG process is well known to those skilled in the art, the details of which are not explained herein for the sake of brevity.

It should be noted that as shown from the top view perspective of Fig. 10, the fin-shaped structures 20 including the source/drain region 60 and the fin-shaped structures 20 directly under and overlapped by the gate structure 58 on the HV region 14 are disposed extending along the Y-direction and two sides such as the top side and bottom side of the fin-shaped structures 20 including the source/drain region 60 are aligned with top side and bottom side of the fin-shaped structures 20 directly under the gate structure 58 along X-direction. Even though the fin-shaped structures 20 including the source/drain region 60 and the fin-shaped structures 20 directly under the gate structure 58 on the LV region 16 are also extending along the Y-direction, only one side of the fin-shaped structure 20 including the source/drain region 60 is aligned with one side of the fin-shaped structures 20 directly under the gate structure 58.

Viewing from another perspective, the fin-shaped structure 20 including the source/drain region 60 and the fin-shaped structure 20 directly under the gate structure 58 on the HV region 14 are different fin-shaped structures, whereas the fin-shaped structure 20 including source/drain region 60 and the fin-shaped structure 20 directly under the gate structure 58 on the LV region 16 are the same fin-shaped structure. Moreover, each of the gate structures 58 on the HV region 14 and LV region 16 includes at least a long side extending along the X-direction and at least a short side extending along the Y-direction, in which the fin-shaped structures 20 including the source/drain region 60 on the HV region 14 are disposed adjacent to two sides of the short side whereas the fin-shaped structures 20 including the source/drain region 60 on the LV region 16 are disposed adjacent to two sides of the long side.

As shown in the cross-section view of Fig. 11, the bottom surface of the gate oxide layer 46 on the HV region 14 includes multiple bumps 48 disposed on and directly contacting the fin-shaped structures 20 and the top surface of the gate oxide layer 46 also includes multiple bumps 50, in which the bottom bumps 48 are all higher than the top surface of the fin-shaped structures 20 and not lower than the sidewalls of the fin-shaped structures 20 underneath, and the top surface of the bumps 50 could be lower than, even with, or higher than the top surface of the source/drain region 60 and/or epitaxial layers 62 on adjacent two sides.

Overall, the present invention disclose an approach for integrating HV device and LV device, which first forms a plurality of fin-shaped structures 20 on the HV region and LV region, and then form a gate oxide layer 46 extending on and directly contact multiple fin-shaped structures underneath. According to a preferred embodiment of the present invention, by forming a plurality of fin-shaped structures on the HV region, it would be desirable to extend the channel length between source region and drain region on the HV region and relieve loading of high voltage in the HV device.

## Claims

1. A method for fabricating a semiconductor device, comprising:
providing a substrate (12) having a high-voltage, HV, region (14) and a low-voltage, LV, region (16);
forming first fin-shaped structures (20) on the HV region (14); and
performing an oxidation process to form a gate oxide layer (46) on and connecting the first fin-shaped structures (20).

2. The method of claim 1, further comprising:
forming second fin-shaped structures adjacent to two sides of the first fin-shaped structures (20) on the HV region (14) and third fin-shaped structures on the LV region (16);
forming a first shallow trench isolation, STI, (32) around the first fin-shaped structures (20), the second fin-shaped structures, and the third fin-shaped structures;
forming a second STI between the first fin-shaped structures and the second fin-shaped structures;
removing the first STI and the second STI on the HV region (14);
forming the gate oxide layer (46) on the first fin-shaped structures (20);
removing the first STI (32) and the second STI on the LV region (16); and
forming epitaxial layers (62) on the second fin-shaped structures.

3. The method of claim 2, wherein a bottom surface of the second STI is lower than a bottom surface of the first STI (32).

4. The method of claim 2, wherein a bottom surface of the first STI (32) is even with a bottom surface of the first fin-shaped structures (20).

5. The method of one of the claims 2 to 4, further comprising forming epitaxial layers (62) on the third fin-shaped structures.

6. The method of one of the claims 1 to 5, wherein a bottom surface of the gate oxide layer (46) comprises first bumps (48) on the first fin-shaped structures (20).

7. The method of one of the claims 1 to 6, wherein a top surface of the gate oxide layer (46) comprises second bumps (50).

8. A semiconductor device, comprising:
a substrate (12) having a high-voltage, HV, region (14) and a low-voltage, LV, region (16);
first fin-shaped structures (20) on the HV region (14); and
a gate oxide layer (46) on and connecting the first fin-shaped structures (20).

9. The semiconductor device of claim 8, further comprising:
Second fin-shaped structures adjacent to two sides of the first fin-shaped structures (20) on the HV region (14);
third fin-shaped structures on the LV region (16);
a first shallow trench isolation, STI, (32) around the first fin-shaped structures (20), the second fin-shaped structures, and the third fin-shaped structures;
a second STI between the first fin-shaped structures and the second fin-shaped structures; and
epitaxial layers (62) on the second fin-shaped structures.

10. The semiconductor device of claim 9, wherein a bottom surface of the second STI is lower than a bottom surface of the first STI (32).

11. The semiconductor device of claim 9, wherein a bottom surface of the first STI (32) is even with a bottom surface of the first fin-shaped structures (20).

12. The semiconductor device of one of the claims 8 to 11, wherein a bottom surface of the gate oxide layer (46) comprises first bumps (48) on the first fin-shaped structures (20).

13. The semiconductor device of one of the claims 8 to 12, wherein a top surface of the gate oxide layer (46) comprises second bumps (50).
